# EUROPÄISCHE PATENTSCHRIFT

(11) **EP 0 786 856 B1**
(45) Veröffentlichungstag und Bekanntmachung des Hinweises auf die Patenterteilung: **15.03.2000**
(21) Anmeldenummer: 96120675.2
(22) Anmeldetag: 20.12.1996
(51) Int. Cl.: H02K 29/08, G01D 11/24

(54) **Schaltungsanordnung insbesondere für kollektorlose Gleichstrom-Motoren**
Switching device for brushless DC motor
Dispositif de commutation pour moteur à courant continu sans balais

(30) Priorität: 24.01.1996 DE 29601163 U
(43) Veröffentlichungstag der Anmeldung: 30.07.1997
(73) Patentinhaber: ebm Werke GmbH & Co., 74673 Mulfingen (DE)
(72) Erfinder: Best,Dieter, 74653 Ingelfingen (DE)
(74) Vertreter: Patentanwälte Dr. Solf & Zapf

(56) Entgegenhaltungen:
- EP-A- 0 547 935
- DE-A- 3 235 204
- PATENT ABSTRACTS OF JAPAN vol. 018, no. 088 (E-1507), 14.Februar 1994 & JP 05 292728 A (DAIKIN IND LTD), 5.November 1993,

## Beschreibung

Die vorliegende Erfindung betrifft eine Schaltungsanordnung, insbesondere für die Kommutierung von kollektorlosen Gleichstrom-Motoren entsprechend dem Oberbegriff des Anspruchs 1.

Die DE-A-32 35 204 beschriebt bereits eine dem Oberbegriff entsprechende Schaltungsanordnung. Auch dabei wird ein Bauteil, insbesondere ein Hall-IC, in einer Aufnahme eines Trägerelementes positioniert. Das Trägerelement weist dabei jedoch lediglich Zentrierzapfen auf, die in entsprechende Löcher der Leiterplatte eingesteckt werden, bis die Fläche, an der die Zentrierzapfen angespritzt sind, an der Leiterplatte anliegt. Deshalb wird durch dieses bekannte Trägerelement keine direkte Halterungsverbindung mit der Leiterplatte erreicht, sondern die eigentliche Halterung erfolgt durch das Festlöten der Anschlußbeinchen des Hall-IC.

Bei der aus der EP-A 0 547 935 bekannten Schaltungsanordnung ist ebenfalls ein Halteteil für Hallelemente vorgesehen. Dieses Halteteil wird mit einem Einsteckabschnitt in eine Lochöffnung der Leiterplatte eingesteckt. Eine Ausrichtung bzw. Fixierung in Verdrehrichtung erfolgt aber erst durch die in entsprechende Anschlußlöcher eingesteckten Anschlußbeinchen der Hallelemente.

Bei derartigen Schaltungsanordnungen werden elektronische Bauteile über ihre Anschlußdrähte elektrisch mit der Leiterplatte verbunden, wodurch in den meisten Fällen auch gleichzeitig die (alleinige) mechanische Halterung des Bauteils an der Leiterplatte gewährleistet ist, so daß keine gesonderten Haltemittel vorgesehen sind. Vor allem bei solchen Bauteilen, die nicht in unmittelbarer Nähe der Leiterplatte angeordnet sind oder sogar auf ihr aufliegen, sondern über längere Anschlußdrähte in einem bestimmten Abstand von der Leiterplatte angeordnet sind, kann dies zu Problemen, wie z.B. zu vibrationsbedingten Störungen und/ oder zu Lageveränderungen durch Verbiegungen der Anschlußdrähte, führen. Dies ist beispielsweise bei Sensoren problematisch, wenn sie zur Erfassung von bestimmten physikalischen Zustandsgrößen relativ zu bestimmten Komponenten genau plaziert werden müssen.

Der vorliegenden Erfindung liegt die Aufgabe zugrunde, eine Schaltungsanordnung zu schaffen, bei der auch solche Bauteile, die über längere Anschlußleiter von der Leiterplatte beabstandet sind, dauerhaft fest und bezüglich ihrer Lage im Raum genau positioniert gehaltert werden können.

Diese Aufgabe wird erfindungsgemäß durch die Merkmale des Anspruchs 1 gelöst.

Die erfindungsgemäße Schaltungsanordnung eignet sich insbesondere für kollektorlose Gleichstrom-Motoren, wobei durch die Erfindung erreicht wird, daß nach einer räumlich definierten Befestigung der Leiterplatte am Motor zwangsläufig auch das jeweilige Bauteil, insbesondere ein Hall-Element (Hall-IC), relativ zu dem Motor bzw. zu dem bezüglich seiner Drehstellung zu detektierenden Rotor sehr genau positioniert ist. Lageveränderungen des Bauteils, wie sie etwa durch Verbiegen der Anschlußleiter auftreten könnten, sind durch die Erfindung somit praktisch ausgeschlossen. Hierdurch wird eine gleichbleibend optimale Kommutierung durch sehr exakte sensorische Erfassung der Rotor-Drehstellung erreicht.

Die Erfindung ist somit vor allem für solche Anwendungsfälle besonders vorteilhaft, bei denen das jeweilige Bauteil funktionsbedingt über seine Anschlußleiter relativ weit von der Leiterplatte beabstandet ist, um selbst in einem Bereich angeordnet zu sein, in dem es bestimmte Aufgaben erfüllen soll, insbesondere die sensorische Erfassung von physikalischen Zustandsgrößen. Beispielsweise ist bei einem kollektorlosen Gleichstrom-Motor die die Steuerung tragende Leiterplatte im Bereich "oberhalb" des Wickelkopfes des Stators angeordnet, während das/jedes Hall-Element in axialer Richtung möglichst nah am Rotor plaziert werden muß oder sogar axial zwischen den Stator und den Rotor eingreift. Für diesen Fall hat das erfindungsgemäße Halteteil eine schlanke, langgestreckte Raumform; gegebenenfalls kann es hierbei vorteilhaft sein, wenn das Bauteil bereichweise aus der Aufnahme des Halteteils nach außen vorragt. Hierdurch können eventuelle Kollisionen zwischen dem erfindungsgemäßen Halteteil und anderen in diesem Bereich befindlichen Komponenten vermieden werden.

Es ist besonders vorteilhaft, wenn das (jedes) Halteteil lösbar an der Leiterplatte gehaltert ist, und zwar insbesondere nach Art einer Bajonettverbindung. Es kann aber mit Vorteil auch eine Rastverbindung (schnappbare Form- oder Kraftformschlußverbindung) vorgesehen sein. Dabei ist das Halteteil praktisch "stehend" auf einer Seite der Leiterplatte befestigt.

Das erfindungsgemäße Halteteil ist zwar ein zusätzliches Element, es kann aber dennoch recht preiswert, insbesondere als Kunststoff-Formteil, hergestellt und auch auf einfache Weise kostengünstig montiert werden. Der funktionelle Nutzen überwiegt somit jedenfalls den geringfügigen Mehraufwand.

Weitere vorteilhafte Ausgestaltungsmerkmale der Erfindung sind in den Unteransprüchen und der folgenden Beschreibung enthalten.

Anhand eines in der Zeichnung dargestellten, bevorzugten Ausführungs- und Anwendungsbeispiels soll im folgenden die Erfindung näher erläutert werden. Dabei zeigen:
- Fig. 1: eine Draufsicht auf die den - hier vorgesehenen mindestens drei - Bauteilen abgekehrte Unterseite eines Teils einer Leiterplatte der erfindungsgemäßen Schaltungsanordnung,
- Fig. 2: eine Ansicht eines erfindungsgemäßen Halteteils vor seiner Montage an der Leiterplatte (Blickrichtung wie in Fig. 1),
- Fig. 3: eine Seitenansicht der Leiterplatte in Pfeilrichtung III gemäß Fig. 1 auf den Bereich eines der Bauteile mit dem erfindungsgemäßen Halteteil in einer ersten Ausführungsform der Schaltungsanordnung,
- Fig. 4: einen Schnitt in der Schnittebene IV-IV gemäß Fig. 3,
- Fig. 5: eine Ansicht wie in Fig. 3, jedoch in einer führungsvariante,
- Fig. 6: eine Schnittansicht analog zu Fig. 4 in der Schnittebene VI-VI gemäß Fig. 5,
- Fig. 7: eine Ansicht wie in Fig. 3 bzw. 5 während der Montage des Bauteils und
- Fig. 8: einen Schnitt längs der Linie VIII-VIII gemäß Fig. 7 mit Blickrichtung in Richtung der eingezeichneten Pfeile.

Gleiche Teile sind stets mit den gleichen Bezugszeichen versehen und brauchen daher in der Regel nur jeweils einmal beschrieben zu werden.

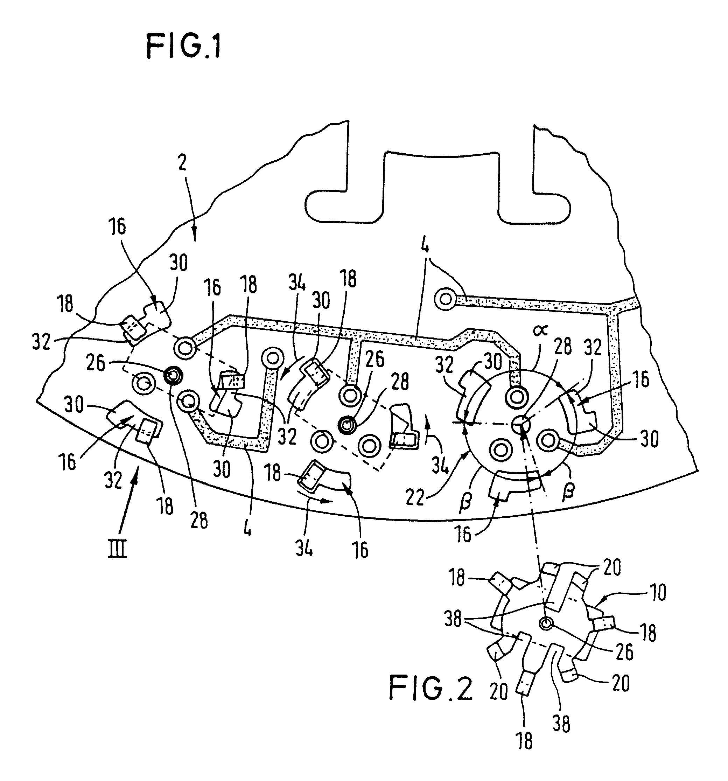

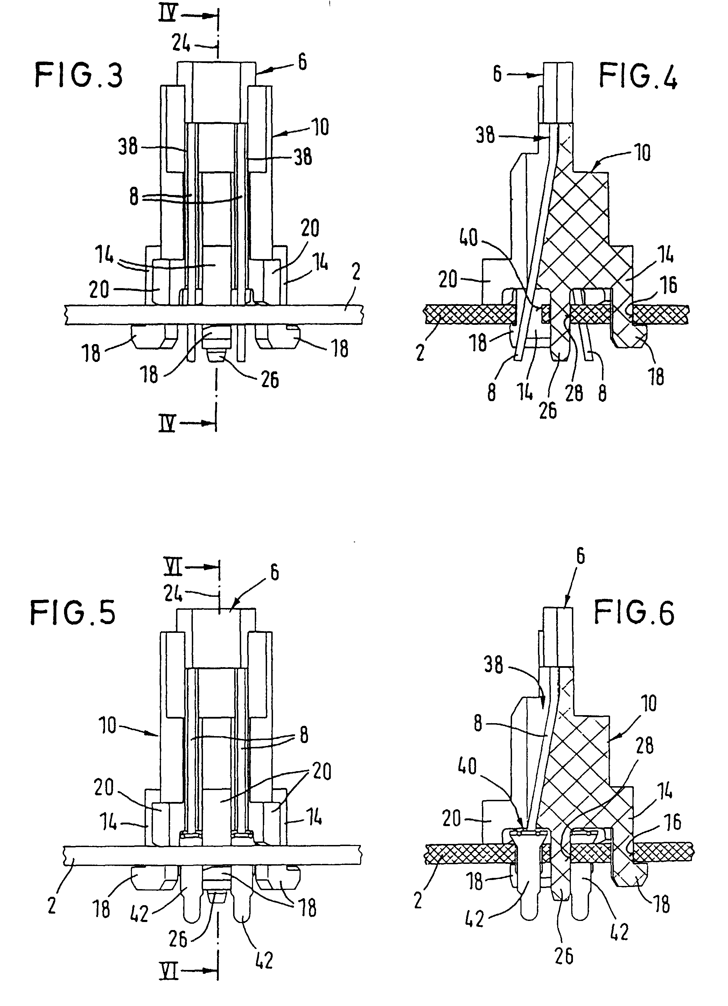

Eine erfindungsgemäße Schaltungsanordnung weist eine Leiterplatte 2 auf, die eine elektronische Schaltung mit über Leiterbahnen 4 (in Fig.1 nur zum Teil dargestellt) elektrisch verschalteten Bauteilen trägt, von denen in den Fig. 3 bis 7 jeweils nur ein spezielles, als Hall-Element oder dergleichen Sensor ausgebildetes Bauteil 6 dargestellt ist. Bei der Schaltungsanordnung handelt es sich insbesondere um eine Kommutierungssteuerung für einen kollektorlosen, elektronisch kommutierten Gleichstrom-Motor, wobei die Anzahl der Bauteile 6 je nach Motorausführung bzw. Polzahl variieren kann; im dargestellten Beispiel sind gemäß Fig. 1 drei Bauteile bzw. Hall-Elemente 6 vorgesehen. Jedes der Bauteile 6 ist über üblicherweise drahtförmige Anschlußleiter 8 mit bestimmten Leiterbahnen 4 der Leiterplatte 2 elektrisch leitend verbunden, wobei das Bauteil 6 in zur Leiterplatte 2 im wesentlichen senkrechter Richtung von letzterer beabstandet ist.

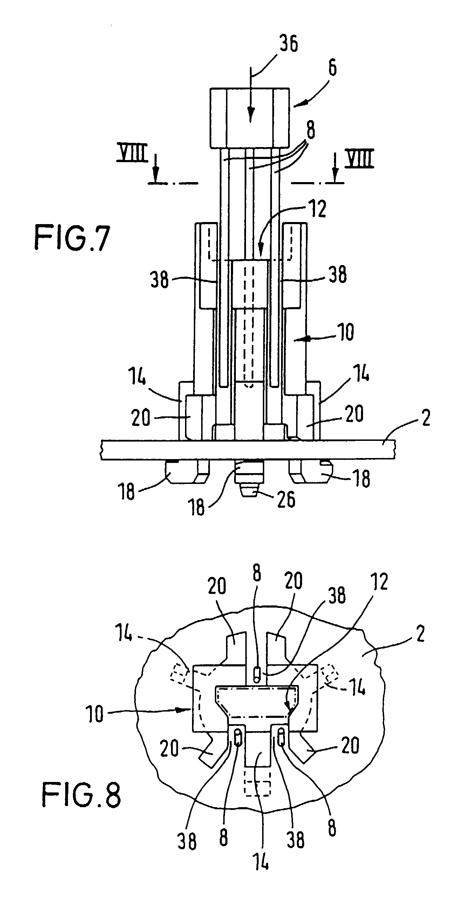

Erfindungsgemäß ist nun jedes dieser speziellen Bauteile bzw. Hall-Elemente 6 über ein Halteteil 10 (Fig. 2 bis 8) in relativ zur Leiterplatte 2 genau definierter Anordnung und Ausrichtung gehalten, indem das Halteteil 10 seinerseits in definierter relativer Anordnung und Ausrichtung zur Leiterplatte - insbesondere unmittelbar, gegebenenfalls aber je nach Anwendungsfall auch mittelbar - an der Leiterplatte 2 gehaltert ist. Das jeweilige Bauteil 6 sitzt hierbei durch Kraft- und/oder Formschluß fixiert zumindest bereichsweise in einer Aufnahme 12 des Halteteils 10 (siehe hierzu insbesondere Fig. 7 und 8).

Zweckmäßigerweise ist das bzw. jedes Halteteil 10 lösbar an der Leiterplatte 2 gehaltert. Hierzu kann mit Vorteil beispielsweise eine Rastverbindung vorgesehen sein. Im dargestellten, bevorzugten Ausführungsbeispiel ist hierzu aber eine Art Bajonettverbindung vorgesehen.

Für die Verbindung mit der Leiterplatte 2 weist das bzw. jedes Halteteil 10 mindestens zwei, wie dargestellt, vorzugsweise aber drei Haltebeine 14 auf, wobei jedes Haltebein 14 eine mit einer Halteöffnung 16 der Leiterplatte 2 zur form- oder kraftformschlüssigen Halterung zusammenwirkende Halteklaue 18 aufweist. Im mit der Leiterplatte 2 verbundenen Zustand des Halteteils 10 hintergreift jede Halteklaue 18 die Leiterplatte 2 durch die jeweilige Halteöffnung 16 hindurch. Die Leiterplatte 2 sitzt dann im wesentlichen spielfrei zwischen den Halteklauen 18 und auf der gegenüberliegenden Plattenseite befindlichen Auflageabschnitten 20 des Halteteils 10 (s. insbesondere Fig. 3 bis 7). Wie dargestellt, sind die Auflageabschnitte 20 jeweils in den zwischen den Haltebeinen 14 liegenden Bereichen angeordnet, so daß sich in Umfangsrichtung die Haltebeine 14 und die Auflageabschnitte 20 jeweils abwechseln.

Hierbei ist nun vorteilhafterweise vorgesehen, daß die Halteklauen 18 in nur einer definierten Drehstellung des Halteteils 10 in die zugehörigen Halteöffnungen 16 der Leiterplatte 2 (s. inbesondere Fig. 1) eingesetzt werden können. Hierzu sind die Halteklauen 18 und die Halteöffnungen 16 jeweils über einen in Fig. 1 angedeuteten Kreisbogen 22 um eine senkrecht zur Leiterplatte 2 verlaufende Einsetzachse 24 (vgl. Fig. 3 und 5) des Halteteils 10 herum ungleichmäßig verteilt angeordnet. Wie sich aus Fig. 1 ergibt, sind die Halteklauen 18 bzw. die Halteöffnungen 16 in Umfangsrichtung jeweils um einen bestimmten Abstandswinkel α, β voneinander beabstandet, wobei sich mindestens ein Abstandswinkel - hier der Winkel α - von den anderen Abstandswinkeln β unterscheidet. Hierdurch kann das Halteteil 10 nur in der vorbestimmten Drehausrichtung mit der Leiterplatte 2 verbunden werden.

Es ist zudem besonders vorteilhaft, wenn das Halteteil 10 einen zur Leiterplatte 2 senkrechten, koaxial zur Einsetzachse 24 verlaufenden Zentrieransatz 26 aufweist, der mit einer Zentrieröffnung 28 der Leiterplatte 2 zusammenwirkt und hierbei insbesondere als Drehachse für die bevorzugt vorgesehene Bajonettverbindung dient. Dabei sind dann die Halteöffnungen 16 der Leiterplatte 2 jeweils langlochförmig und entsprechend der Drehbewegung beim Verriegeln bzw. Lösen der Bajonettverbindung kreisbogenförmig gekrümmt mit einem erweiterten Einführbereich 30 und einem verengten Haltebereich 32 ausgebildet (Fig. 1). Der Einführbereich 30 ermöglicht aufgrund seiner Öffnungsgröße ein Durchführen der zugehörigen Halteklaue 18. Die verengten Haltebereiche 32 bewirken dann das formschlüssige Hintergreifen der Leiterplatte 2 durch die Halteklauen 18, nachdem das Halteteil 10 eingesetzt und in Richtung der in Fig. 1 eingezeichneten Pfeile 34 verdreht wurde.

Wie sich insbesondere aus Fig. 7 und 8 ergibt, ist für die genau positionierte Fixierung des Bauteils 6 vorgesehen, daß die Aufnahme 12 des Halteteils 10 derart an die äußere Raumform des Bauteils 6 angepaßt ist, daß letzteres in einer zur Leiterplatte 2 im wesentlichen senkrechten Richtung (entspricht dem Verlauf der Einsetzachse 24) in Pfeilrichtung 36 gemäß Fig. 7 in die Aufnahme 12 einsetzbar (einsteckbar) ist. Das Bauteil 6 sitzt dann durch Kraft-und/oder Formschluß fixiert in der Aufnahme 12.

Wie sich ferner aus den Zeichnungsfiguren ergibt, weist das Halteteil 10 ausgehend von der Aufnahme 12 in Richtung zur Leiterplatte 2 führende Öffnungen 38 für die Anschlußleiter 8 des Bauteils 6 auf. Hierbei ist es besonders vorteilhaft, wenn diese Öffnungen 38 derart "führungskanalartig" ausgebildet sind, daß hierdurch die Anschlußleiter 8 des Bauteils 6 beim Einsetzen im wesentlichen selbsttätig in zugeordnete Kontaktöffnungen 40 der Leiterplatte 2 eingeführt werden.

Diesbezüglich sind nun in den Fig. 3 und 4 einerseits und den Fig. 5 und 6 andererseits zwei Ausführungsvarianten veranschaulicht. Im Falle der Fig. 3 und 4 sind die Kontaktöffnungen 40 als Durchgangslöcher der Leiterplatte 2 im Bereich von Leiterbahnen 4 gebildet. Hierbei erfolgt die elektrische Verbindung durch unmittelbares Verlöten der Anschlußleiter 8 mit den Leiterbahnen 4. Dabei wird zunächst das Halteteil 10 mit der Leiterplatte 2 verbunden. Danach wird das Bauteil 6 eingesetzt, und die Anschlußleiter 8 werden verlötet. Dies kann mit Vorteil in einem Lötbad erfolgen. Diese Ausführung nach Fig. 3 und 4 ist vor allem dann geeignet, wenn die Leiterplatte 2 nur auf der Seite des Bauteils 6 weitere Bauteile trägt. Sollten jedoch (auch) auf der dem Bauteil 6 gegenüberliegenden Seite der Leiterplatte 2 weitere Bauteile angeordnet sein, so kann hierbei vorgesehen sein, daß die Kontaktöffnungen 40 zunächst mit einem geeigneten Material ("Stopfmaterial") verschlossen sind, um die gegenüberliegenden Bauteile in einem Lötbad verlöten zu können, ohne die für das Bauteil 6 bzw. dessen Anschlußleiter 8 vorgesehenen Kontaktöffnungen 40 mit Lötzinn zu verschließen. Erst danach wird das Halteteil 10 montiert und das Bauteil 6 eingesetzt, wobei dann das "Stopfmaterial" von den Anschlußleitern 8 durchstoßen wird. Die Anschlußleiter 8 werden dann insbesondere manuell verlötet. Das "Stopfmaterial" bewirkt somit, daß die Kontaktöffnungen 40 zum Durchführen der Anschlußleiter 8 frei von Lötzinn bleiben.

Im Falle der Fig. 5 und 6 sind die Kontaktöffnungen 40 als Einstecköffnungen von im Bereich von Leiterbahnen 4 mit der Leiterplatte 2 verbundenen Steckkontakthülsen 42 gebildet. In diesem Fall werden die Kontakthülsen 42 - zusammen mit weiteren Bauelementen - in einem Lötbad verlötet. Hierbei können die weiteren Bauteile (auch) auf der dem Bauteil 6 gegenüberliegenden Seite angeordnet sein. Die Einstecköffnungen bzw. Kontaktöffnungen 40 der Kontakthülsen 42 sind hierbei - zum Schutz von vorzugsweise vergoldeten Kontaktelementen gegen Lötzinn - zunächst mit "Stopfmaterial" verschlossen. Danach wird das Halteteil 10 montiert, indem es über die Kontakthülsen 42 geschoben und insbesondere zum Verriegeln der Bajonettverbindung verdreht wird. Abschließend werden beim Einstecken des Bauteils 6 dessen Anschlußleiter 8 durch das "Stopfmaterial" hindurch in die Kontakthülsen 42 eingesteckt, wodurch die elektrisch leitende Verbindung erfolgt. Diese Ausführung nach Fig. 5 und 6 wird bevorzugt, wenn weitere Bauteile auf der dem Bauteil 6 gegenüberliegenden Seite der Leiterplatte 2 angeordnet sind.

In beiden Ausführungsvarianten sind die Kontaktöffnungen 40 innerhalb eines von den Haltebeinen 14 des Halteteils 10 bzw. von den Halteöffnungen 16 der Leiterplatte 2 definierten bzw. begrenzten Flächenbereichs der Leiterplatte 2 angeordnet, so daß sie praktisch vom Halteteil 10 überdeckt werden.

Das Halteteil 10 ist vorteilhafterweise als einstückiges Formteil aus Kunststoff gebildet und daher sehr preiswert herstellbar.

## Patentansprüche

1. Schaltungsanordung, insbesondere für die Kommutierung von kollektorlosen Gleichstrom-Motoren, mit einer Leiterplatte (2) und mindestens einem elektronischen, über Anschlußleiter (8) mit Leiterbahnen (4) der Leiterplatte (2) verbundenen Bauteil (6), das insbesondere ein Hall-Element oder dergleichen Rotor-Drehstellungsdetektor ist, wobei das Bauteil (6) in einer Aufnahme (12) eines Halteteils (10) in relativ zur Leiterplatte (2) definiert fixierter Anordnung und Ausrichtung gehalten ist,
**dadurch gekennzeichnet,**
daß das Halteteil (10) zur Halterung an der Leiterplatte (2) in einer zu dieser definierten relativen Anordnung und Ausrichtung mindestens zwei Haltebeine (14) aufweist, wobei jedes Haltebein (14) eine mit einer Halteöffnung (16) der Leiterplatte (2) zur formoder kraftformschlüssigen Halterung zusammenwirkende Halteklaue (18) aufweist und die Halteklauen (18) und die Halteöffnungen (16) jeweils um eine senkrecht zur Leiterplatte (2) verlaufende Einsetzachse (24) des Halteteils (10) herum verteilt angeordnet sind, und zwar derart ungleichmäßig, daß das Halteteil (10) in nur einer definierten Drehausrichtung mit der Leiterplatte (2) verbindbar ist.

2. Schaltungsanordnung nach Anspruch 1,
**dadurch gekennzeichnet,**
daß das Halteteil (10) über die Haltebeine (14) lösbar, insbesondere nach Art einer Bajonettverbindung oder über Rastverbindungen, an der Leiterplatte (2) gehaltert ist.

3. Schaltungsanordnung nach Anspruch 1 oder 2,
**dadurch gekennzeichnet,**
daß das Halteteil (10) drei Haltebeine (14) aufweist.

4. Schaltungsanordnung nach einem oder mehreren der Ansprüche 1 bis 3,
**dadurch gekennzeichnet,**
daß jede Halteklaue (18) die Leiterplatte (2) durch die jeweilige Halteöffnung (16) hindurch hintergreift, wobei die Leiterplatte (2) im wesentlichen spielfrei zwischen den Halteklauen (18) und auf der gegenüberliegenden Seite befindlichen Auflageabschnitten (20) des Halteteils (10) sitzt.

5. Schaltungsanordnung nach einem oder mehreren der Ansprüche 1 bis 4,
**dadurch gekennzeichnet,**
daß die Halteklauen (18) in Umfangsrichtung jeweils um einen bestimmten Abstandswinkel (α, β) voneinander beabstandet sind, wobei sich mindestens ein Abstandswinkel (α) von dem/den jeweils anderen Abstandswinkel/n (β) unterscheidet.

6. Schaltungsanordung nach einem oder mehreren der Ansprüche 1 bis 5,
**dadurch gekennzeichnet,**
daß das Halteteil (10) einen zur Leiterplatte (2) senkrechten, koaxial zur Einsetzachse (24) verlaufenden Zentrieransatz (26) aufweist, der mit einer Zentrieröffnung (28) der Leiterplatte (2) zusammenwirkt und insbesondere als Drehachse für die bevorzugte Bajonettverbindung dient.

7. Schaltungsanordnung nach einem oder mehreren der Ansprüche 1 bis 6,
**dadurch gekennzeichnet,**
daß die Halteöffnungen (16) der Leiterplatte (2) jeweils langlochförmig mit einem erweiterten Einführbereich (30) und einem verengten Haltebereich (32) ausgebildet sind.

8. Schaltungsanordnung nach einem oder mehreren der Ansprüche 1 bis 7,
**dadurch gekennzeichnet,**
daß die Aufnahme (12) des Halteils (10) derart an die äußere Form des Bauteils (6) angepaßt ist, daß das Bauteil (6) in einer zur Leiterplatte (2) im wesentlichen senkrechten Richtung in die Aufnahme (12) einsetzbar ist.

9. Schaltungsanordnung nach einem oder mehreren der Ansprüche 1 bis 8,
**dadurch gekennzeichnet,**
daß das Halteteil (10) von der Aufnahme (12) ausgehende und in Richtung der Leiterplatte (2) führende, insbesondere schlitzartige Öffnungen (38) für die Anschlußleiter (8) des Bauteils (6) aufweist.

10. Schaltungsanordnung nach Anspruch 9,
**dadurch gekennzeichnet,**
daß die Öffnungen (38) des Halteteils (10) derart führungskanalartig ausgebildet sind, daß die insbesondere aus Drähten bestehenden Anschlußleiter (8) des Bauteils (6) beim Einsetzen im wesentlichen selbsttätig in Kontaktöffnungen (40) der Leiterplatte (2) eingeführt werden.

11. Schaltungsanordnung nach Anspruch 10,
**dadurch gekennzeichnet,**
daß die Kontaktöffnungen (40) innerhalb eines von den Haltebeinen (14) des Halteteils (16) bzw. von den Halteöffnungen (16) der Leiterplatte (2) definierten Flächenbereiches der Leiterplatte (2) angeordnet sind.

12. Schaltungsanordnung nach Anspruch 10 oder 11,
**dadurch gekennzeichnet,**
daß die Kontaktöffnungen (40) als Durchgangslöcher der Leiterplatte (2) gebildet sind.

13. Schaltungsanordnung nach Anspruch 10 oder 11,
**dadurch gekennzeichnet,**
daß die Kontaktöffnungen (40) als Einstecköffnungen von mit der Leiterplatte (2) verbundenen SteckKontakthülsen (42) gebildet sind.

14. Schaltungsanordnung nach einem oder mehreren der Ansprüche 1 bis 13,
**dadurch gekennzeichnet,**
daß das Halteteil (10) als einstückiges Formteil aus Kunststoff gebildet ist.

15. Schaltungsanordnung nach einem oder mehreren der Ansprüche 1 bis 14,
**dadurch gekennzeichet,**
daß mit der Leiterplatte (2) mehrere, insbesondere drei Bauteile (6) mit jeweils einem Halteteil (10) verbunden sind.

## Claims

1. Circuit arrangement, in particular for the commutation of brushless DC motors, having a printed circuit board (2) and at least one electronic component (6) which is connected via connecting conductors (8) to conductor tracks (4) on the printed circuit board (2) and is, in particular, a Hall element or a similar rotor rotation-position detector, in which case the component (6) is held in a holder (12) of a retaining part (10) in an arrangement and alignment fixed in a defined manner with respect to the printed circuit board (2),
characterized
in that the retaining part (10) has at least two retaining legs (14) for retention on the printed circuit board (2) in a relative arrangement and alignment defined with respect to the printed circuit board, in which case each retaining leg (14) has a retaining claw (18) which interacts with a retaining opening (16) in the printed circuit board (2) to provide positively-locking or force-fitting retention, and the retaining claws (18) and the retaining openings (16) are each arranged distributed around an insertion axis (24) of the retaining part (10) running at right angles to the printed circuit board (2), to be precise non-uniformly, in such a manner that the retaining part (10) can be connected to the printed circuit board (2) in only one defined rotation alignment.

2. Circuit arrangement according to Claim 1,
characterized
in that the retaining part (10) is held detachably, in particular like a bayonet connection or by latching connections, on the printed circuit board (2) via the retaining legs (14).

3. Circuit arrangement according to Claim 1 or 2,
characterized
in that the retaining part (10) has three retaining legs (14).

4. Circuit arrangement according to one or more of Claims 1 to 3,
characterized
in that each retaining claw (18) engages behind the printed circuit board (2) through the respective retaining opening (16), with the printed circuit board (2) being seated essentially without any play between the retaining claws (18) and bearing sections (20) (which are located on the opposite side) of the retaining part (10).

5. Circuit arrangement according to one or more of Claims 1 to 4,
characterized
in that the retaining claws (18) are each spaced apart from one another in the circumferential direction by a specific separation angle (α, β), with at least one separation angle (α) differing from the respective other separation angle or angles (β).

6. Circuit arrangement according to one or more of Claims 1 to 5,
characterized
in that the retaining part (10) has a centring attachment (26) which is at right angles to the printed circuit board (2), runs coaxially with respect to the insertion axis (24), interacts with a centring opening (28) in the printed circuit board (2) and is used, in particular, as rotation shaft for the preferred bayonet connection.

7. Circuit arrangement according to one or more of Claims 1 to 6,
characterized
in that the retaining openings (16) in the printed circuit board (2) are each formed as elongated holes with an enlarged insertion region (30) and a narrowed retaining region (32).

8. Circuit arrangement according to one or more of Claims 1 to 7,
characterized
in that the holder (12) for the retaining part (10) is matched to the external shape of the component (6) in such a manner that the component (6) can be inserted into the holder (12) in a direction essentially at right angles to the printed circuit board (2).

9. Circuit arrangement according to one or more of Claims 1 to 8,
characterized
in that the retaining part (10) has openings (38), which originate from the holder (12), lead in the direction of the printed circuit board (2) and, in particular, are like slots, for the connecting conductors (8) of the component (6).

10. Circuit arrangement according to Claim 9,
characterized
in that the openings (38) in the retaining part (10) are designed like guide channels in such a manner that the connecting conductors (8) (which consist, in particular, of wires) of the component (6) are essentially automatically inserted into contact openings (40) in the printed circuit board (2) during insertion.

11. Circuit arrangement according to Claim 10,
characterized
in that the contact openings (40) are arranged inside a surface region of the printed circuit board (2) which is defined by the retaining legs (14) of the retaining part (16) or by the retaining openings (16) in the printed circuit board (2).

12. Circuit arrangement according to Claim 10 or 11,
characterized
in that the contact openings (40) are formed as through-holes in the printed circuit board (2).

13. Circuit arrangement according to Claim 10 or 11,
characterized
in that the contact openings (40) are formed as insertion openings of plug contact sleeves (42) which are connected to the printed circuit board (2).

14. Circuit arrangement according to one or more of Claims 1 to 13,
characterized
in that the retaining part (10) is formed as an integral moulding composed of plastics material.

15. Circuit arrangement according to one or more of Claims 1 to 14,
characterized
in that a plurality of components (6), in particular three, are connected to the printed circuit board (2) by in each case one retaining part (10).

## Revendications

1. Dispositif de connexion, en particulier pour la commutation de moteur à courant continu sans collecteur, comprenant un circuit imprimé (2) et au moins un composant électronique (6) qui est relié par des conducteurs de connexion (8) à des pistes conductrices (4) du circuit imprimé (2), et qui est en particulier un élément Hall ou un détecteur de position de rotation du rotor du même genre, le composant (6) étant retenu dans un logement (12) d'un élément de retenue (10) dans une disposition et une orientation fixées, définies par rapport au circuit imprimé (2), caractérisé en ce que l'élément de retenue (10) présente, pour être fixé au circuit imprimé (2), dans une disposition et une orientation relatives définies par rapport à ce circuit, au moins deux jambes de retenue (14), chaque jambe de retenue (14) présentant une griffe de retenue (18) coopérant avec une ouverture de retenue (16) du circuit imprimé (2) pour assurer une retenue opérant par sûreté de forme ou par action de force, les griffes de retenue (18) et les ouvertures de retenue (16) étant réparties respectivement autour d'un axe (24) d'insertion de l'élément de retenue (10), qui s'étend perpendiculairement au circuit imprimé (2), et ceci irrégulièrement de manière que l'élément de retenue (10) ne puisse être assemblé au circuit imprimé (2) que dans une orientation de rotation définie.

2. Dispositif de connexion selon la revendication 1, caractérisé en ce que l'élément de retenue (10) est fixé au circuit imprimé (2) de façon démontable, au moyen des jambes de retenue (14), en particulier à la façon d'un assemblage à baïonnette ou d'assemblages à encliquetage.

3. Dispositif de connexion selon la revendication 1 ou 2, caractérisé en ce que l'élément de retenue (10) présente trois jambes de retenue (14).

4. Dispositif de connexion selon une ou plusieurs des revendications 1 à 3, caractérisé en ce que chaque griffe de retenue (18) s'accroche derrière le circuit imprimé (2) en traversant l'ouverture de retenue (16) correspondante, le circuit imprimé (2) étant monté sensiblement sans jeu entre les griffes de retenue (18) et des segments de portée (20) de l'élément de retenue (10) qui se trouvent sur le côté opposé.

5. Dispositif de connexion selon une ou plusieurs des revendications 1 à 4, caractérisé en ce que les griffes de retenue (18) sont espacées l'une de l'autre d'un certain angle d'écartement (α, β) dans la direction circonférentielle, au moins un angle d'écartement (α) étant différent de l'autre ou des autres angle(s) d'écartement (β).

6. Dispositif de connexion selon une ou plusieurs des revendications 1 à 5, caractérisé en ce que l'élément de retenue (10) présente un bossage de centrage (26) perpendiculaire au circuit imprimé (2), qui s'étend coaxialement à l'axe d'insertion (24), et qui coopère avec une ouverture de centrage (28) du circuit imprimé (2) et sert en particulier d'axe de rotation pour l'assemblage à baïonnette préféré.

7. Dispositif de connexion selon une ou plusieurs des revendications 1 à 6, caractérisé en ce que les ouvertures de retenue (16) du circuit imprimé (2) sont réalisées chacune en forme de trou allongé, avec une zone d'engagement élargie (30) et une zone de retenue rétrécie (32).

8. Dispositif de connexion selon une ou plusieurs des revendications 1 à 7, caractérisé en ce que le logement (12) de l'élément de retenue (10) est adapté à la forme extérieure du composant (6) de telle manière que le composant (6) puisse être inséré dans le logement (12) dans une direction sensiblement perpendiculaire au circuit imprimé (2).

9. Dispositif de connexion selon une ou plusieurs des revendications 1 à 8, caractérisé en ce que l'élément de retenue (10) présente des ouvertures (38) en particulier en forme de fente, partant du logement (12) et menant en direction du circuit imprimé (2), pour les conducteurs de connexion (8) du composant (6).

10. Dispositif de connexion selon la revendication 9, caractérisé en ce que les ouvertures (38) de l'élément de retenue (10) sont réalisées en forme de canal de guidage de telle manière que les conducteurs de connexion (8) du composant (6), qui sont en particulier constitués par des fils métalliques, soient engagés sensiblement automatiquement dans des ouvertures de contact (40) du circuit imprimé (2) au cours de l'insertion.

11. Dispositif de connexion selon la revendication 10, caractérisé en ce que les ouvertures de contact (40) sont disposées à l'intérieur d'une région de surface du circuit imprimé (2) qui est définie par les jambes de retenue (14) de l'élément de retenue (16) ou par les ouvertures de retenue (16) du circuit imprimé (2).

12. Dispositif de connexion selon la revendication 10 ou 11, caractérisé en ce que les ouvertures de contact (40) sont constituées par des trous traversant du circuit imprimé (2).

13. Dispositif de connexion selon la revendication 10 ou 11, caractérisé en ce que les ouvertures de contact (40) sont constituées par des ouvertures d'insertion de douilles de contact (42) connectées au circuit imprimé (2).

14. Dispositif de connexion selon une ou plusieurs des revendications 1 à 13, caractérisé en ce que l'élément de retenue (10) est constitué par un élément moulé en matière plastique d'une seule pièce.

15. Dispositif de connexion selon une ou plusieurs des revendications 1 à 14, caractérisé en ce que plusieurs, en particulier trois, composants (6) sont connectés au circuit imprimé (2), chacun au moyen d'un élément de retenue (10).
